# EUROPEAN PATENT SPECIFICATION

(11) **EP 0 413 974 B1**
(45) Date of publication and mention of the grant of the patent: **14.09.1994**
(21) Application number: 90114057.4
(22) Date of filing: 23.07.1990
(51) Int. Cl.: C30B 25/02, C30B 29/04, C23C 16/26

(54) **Method of making a single crystal CVD diamond**
Verfahren zur Herstellung von Diamant-Einkristallen durch chemische Dampfabscheidung
Procédé de péparation de diamant à partir de la phase gazeuse monocristallin par le procédé de dépôt chimique

(30) Priority: 21.08.1989 US 396253
(43) Date of publication of application: 27.02.1991
(73) Proprietor: GENERAL ELECTRIC COMPANY, Schenectady New York 12305 (US)
(72) Inventor: Anthony, Thomas Richard, Schenectady, New York 12309 (US); Fleischer, James Fulton, Scotia, New York 12302 (US)
(74) Representative: Pratt, Richard Wilson

(56) References cited:
- GB-A- 1 298 369
- PATENT ABSTRACTS OF JAPAN, vol. 10, no. 362 (C-389)[2419], 4th December 1986; & JP-A-61 58 898
- PATENT ABSTRACTS OF JAPAN, vol. 10, no. 71 (C-334)[2128], 20th March 1986; & JP-A-60 210 597

## Description

The present invention relates to a method of growing a single diamond crystal by chemical vapor deposition while suppressing secondary polycrystalline diamond nucleation. More particularly, the present invention relates to the use of a high pressure high temperature (HPHT) single crystal diamond seed to initiate diamond growth by chemical vapor deposition (CVD). A mixture of a hydrocarbon and hydrogen is used in the presence of an effective amount of a metallocene.

Prior to the present invention, as taught by P.K. Bachmann, et al, Emergent Technology of Diamond Thin Films, Chemical and Engineering News, May 15, 1989, pages 24-39, and incorporated herein by reference, diamonds were initially produced synthetically from graphite during the early 50's by high pressure, high temperature (HPHT) methods. Although high pressure techniques have been found to provide sufficient amounts of diamond grit for abrasive operations, and large single crystals for electronic component heat sinks, they nevertheless have many limitations. A large, expensive press is required and further scale up is difficult. However, single crystal synthetic HPHT diamonds, which can be in the form of rough, yellow stones about 8 millimeters in diameter, are still in great demand.

During the early '50's at the time high pressure techniques for synthesizing diamonds were being investigated, methods to deposit diamond by chemical vapor deposition (CVD) from a vapor phase reactor by the thermal decomposition of carbon containing gases was also studied. Continuing efforts of various groups also provided a variety of methods to produce synthetic diamonds at low pressure during the early 1980's. One procedure involved the use of a heated filament to generate atomic hydrogen to effect the deposition of diamond films from methane-hydrogen mixtures. Another approach employed a plasma, to effect the deposition of diamond coatings from hydrocarbons.

As shown by Dzevitsky, U.S. patent 3,705,937, synthetic diamonds can be made from seed crystals which can result from the contact of organometallic compounds, such as methyl or ethyl derivatives of lead or mercury at an elevated temperature and reduced pressure. A significant weight gain of diamond powder is reported. Although Dzevitsky,et al's method is effective for generating white diamond powder at a weight gain rate of up to about 2.3% by weight, per hour, it does not provide a method for growing single diamond crystals. An improvement in the growth of ornamental diamonds is reported by Aida, Japanese patent 61,158,898, by using a 0.1 carat single crystal natural diamond in a methane-hydrogen mixture at substrate temperature of 800 to 1100°C. Although the formation of a jewel quality diamond is reported, it has been found that secondary nucleation resulting in the production of polycrystalline material is difficult to suppress.

Additional procedures for generating fine diamond powder useful as abrasives is shown by Japanese patents 60,223,1494 and 60,210,597. A metallocene, such as ferrocene is used to generate fine metallic particles in a plasma, while in the presence of a mixture of a hydrocarbon, such as methane, and hydrogen at low pressure.

Although the various methods of the prior art provide procedures for making finely divided diamond powder useful as abrasives by employing organometallic materials or ornamental diamonds by employing a single crystal natural diamond seed, it would be desirable to grow a single crystal diamond by chemical vapor deposition which would avoid or suppress secondary nucleation resulting in the simultaneous production of polycrystalline diamond.

### Summary of the Invention

The present invention is based on the discovery that large single crystal diamond, which can be dark gray, and lack optical transparency, can be made by using a single crystal seed of a (HPHT) diamond in a hydrogen-methane atmosphere containing a minor amount of a metallocene, such as ferrocene. Suprisingly, secondary nucleation is totally eliminated or suppressed on the surface of the growing diamond crystal.

### Statement of the Invention

There is provided by the present invention, a method for growing a single diamond crystal, while suppressing secondary nucleation, comprising maintaining a hydrocarbon-hydrogen mixture at a pressure of 667Pa to 2000Pa (5 to 15 torr) and at a temperature of about 800°C to 1000°C in contact with an HPHT diamond seed which is at least 0.1 carat, in the presence of 10⁻⁴ to 1% by volume based on the total volume of hydrocarbon-hydrogen mixture of a metallocene or thermal degradation product thereof, where the hydrocarbon in the hydrocarbon-hydrogen mixture has a concentration of about 0.5 to 1.5 volume % of hydrocarbon based on the total volume of hydrocarbon and hydrogen, and is capable of maintaining a 13.3Pa (0.1 torr) vapor pressure under ambient conditions, and the metallocene, or thermal degradation product thereof, is an organometallic compound of a metal selected from the class consisting of iron, cobalt, and nickel.

Metallocenes which can be used in the practice of the present invention are for example, ferrocene, and compounds of nickel such as bis(1-5-cyclooctadiene)nickel, and cobalt such as bis(cyclopentadienyl)cobalt.

Hydrocarbons, which can be used in the practice of the present invention include C₍₁₋₈₎ alkanes, such as methane, ethane, and propane, acetylene, and aromatic compounds such as benzene. An effective amount of metallocene is 10⁻⁴to 1% by volume, and preferably 8x10⁻⁴ to 8x10⁻³ % by volume based on the total volume of the hydrocarbon-hydrogen mixture maintained at a temperature in the range of from 600 to 1000°C and an pressure of 13,3 to 6665Pa (0.1 to 50 torr) and where the hydrocarbon-hydrogen mixture contains from about 0.1 to about 2 % by volume of hydrocarbon based on the total volume of the hydrocarbon-hydrogen mixture.

A preferred procedure of introducing the metallocene into the hydrocarbon-hydrogen mixture is placing a quantity of the metallocene, for example 10 grams of ferrocene in a tubular reactor, such as one end of a 7 x 122cm (2 3/4 inch x 48 inch) quartz tube, under ambient conditions and allowing a mixture of methane and hydrogen as previously defined to pass over the metallocene at ambient temperatures and pressure. It has been found, for example, that a flow rate of a methane-hydrogen mixture sufficient to provide from 1x10⁻³ to 5x10⁻³ % by volume of metallocene, based in the volume of the methane-hydrogen mixture at about atmospheric pressure and ambient temperature will provide an effective concentration of the metallocene in the methane-hydrogen mixture. The metallocene containing hydrogen-methane mixture can then be passed over a diamond seed crystal, which is at least 0.1 carat, or have an average diameter of at least 1000µm (microns), and preferably from 1000 to 4000µm (microns).

Temperatures in the range of from 800°C to 1000°C can be maintained in the metallocene containing methane-hydrogen mixture by employing a heated filament to effect the generation of atomic hydrogen by the thermal decomposition of the methane as described in the above P.K. Bachmann et al article. Other techniques which can be used to generate atomic hydrogen is by use of a microwave plasma as described hereinafter. Further procedures which can be used to maintain the gaseous mixture at an elevated temperature is described by Kazuhiro Suzuki, in the aforementioned article of Bachmann et al, by applying a direct current plasma jet to focus on a small area of substrate. A direct current voltage of more than 1 KV and high discharge currents can sustain a plasma at 3727°C (4000K).

Recovery of the diamond can be readily achieved by allowing the substrate to cool to ambient temperatures.

As further shown by Karl E. Spear, Diamond-Ceramic Coating of the Future, Journal of the American Ceramic Society, 72(2)171-91(1989), incorporated herein by reference, the two common methods for achieving the required activation of the precursor gases to generate the atomic hydrogen used to effect the growth of crystalline diamond is a microwave plasma, or a 2000°C heated filament.

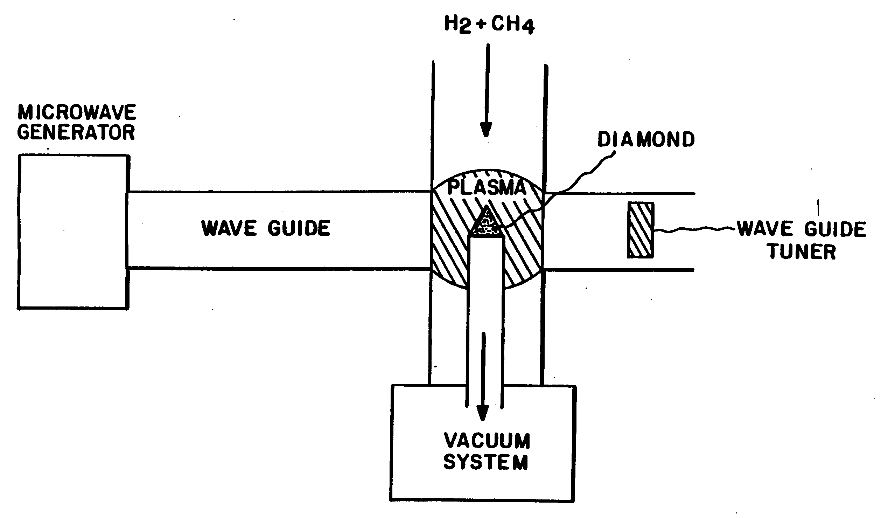

Reference also is made to the drawing which shows a preferred procedure of vapor deposition of diamond growth using a microwave generator to produce a plasma, and a silicon pedestal upon which a single crystal seed of an HPHT diamond is mounted.

More particularly, there is shown in the drawing a microwave generator capable of generating a microwave signal from 2.45 gigaHerz(GHz). A typical microwave generator which can be used in the practice of the invention is, for example, Cober Inc. 10 kw microwave model S6-F generator (Stamford, Conn). There is also shown in the drawing, a wave guide, which is a rectangular hollow steel tube which can be approximately 20 to 122cm (8 to 48 inches) in length and having internal dimensions of about 3.8 x 7.0cm (1 1/2 x 2 3/4 inches). A plasma having a temperature of 500°C to 1100°C is formed when the microwave is operated at from 100 to 500 watts, and at 2.45 gigaHertz. A thermally decomposed metallocene containing methane-hydrogen gaseous mixture, as previously defined, resulting from passage of the methane-hydrogen mixture over the metallocene at room temperature and atmospheric pressure (not shown) is continuously introduced into the plasma. A quartz pedestal, approximately 25.4cm (10 inches) long and 0.32 by 0.32cm. (1/8 by 1/8 inches) provides a substrate surface for holding a single crystal of HPHT diamond which can be 0.1 to 1 carat. A wave guide tuner is also provided as well as a vacuum system to maintain the pressure of the total system from at 13.3 to 6665Pa (.1 to 50 torr).

In order that those skilled in the art will be better able to practice the present invention, the following example is given by way of illustration and not by way of limitation.

### Example

A methane-hydrogen mixture having 1.5% by volume of methane was passed over 10 grams of ferrocene at room temperature and atmospheric pressure. The resulting mixture had 2.6x10⁻³% of ferrocene by volume. The ferrocene containing mixture at a flow rate of 150cc's /min was conveyed through a quartz tube, as shown in the drawing,having a diameter of 5.08cm (2 inches) onto an HPHT diamond seed crystal having a 2.4 millimeter diameter which was situated on the end of a vertically oriented silicon pedestal.

A microwave generator set at 200 watts at 2450 megaHertz was turned on. The temperature of the resulting plasma was found to be 500-700°C around the diamond seed. The growth rate was found to be about 2µm (micron) per hour, and a total of 600µm (microns) of diamond was grown on the seed. There was no visual evidence of secondary nucleation occurring around the surface of the seed crystal. There was obtained after 456 hours, a single crystal of CVD diamond which was dark gray in color having poor optical transparency and a diameter of 3.6 millimeters.

Although the above example is directed to only a few of the very many variables which can be used in the practice of the method of the present invention, it should be understood that the present invention is directed to additional methods of growing single crystal CVD diamond using a much broader variety of conditions, such as a different hydrocarbon, for example, acetylene or a different metallocene, or the use of a heated filament, such as is set forth in the description preceding this example.

## Claims

1. A method for growing a single diamond crystal, while suppressing secondary nucleation, comprising maintaining a hydrocarbon-hydrogen mixture at a pressure of 666 Pa to 2000 Pa (5 to 15 torr) and at a temperature of about 800°C to 1000°C in contact with an HPHT diamond seed which is at least 0.1 carat, in the presence of 10⁻⁴ to 1% by volume, based on the total volume of the hydrocarbon-hydrogen mixture of a metallocene or thermal degradation product thereof, where the hydrocarbon in the hydrocarbon-hydrogen mixture has a concentration of about 0.5 to 1.5 volume % of hydrocarbon based on the total volume of hydrocarbon and hydrogen, and is capable of maintaining a 13.3 Pa (0.1 torr) vapor pressure under ambient conditions, and the metallocene, or thermal degradation product thereof, is an organometallic compound of a metal selected from the class consisting of iron, cobalt, and nickel.

2. A method for growing a single diamond crystal in accordance with Claim 1, where the metallocene is ferrocene.

3. A method in accordance with Claim 1, where the hydrocarbon is methane.

4. A method in accordance with Claim 1, where the temperature is maintained with a microwave plasma.

5. A method in accordance with Claim 1, where the temperature is maintained by using a heated filament.

## Patentansprüche

1. Verfahren zum Züchten von einkristallinem Diamant, während eine sekundäre Kistallkeimbildung unterdrückt wird, umfassend das Aufrechterhalten einer Kohlenwasserstoff-Wasserstoff-Mischung bei einem Druck von 666 Pa bis 2.000 Pa (5 - 15 Torr) und bei einer Temperatur von etwa 800°C bis 1.000°C, in Kontakt mit einem bei hohem Druck und hoher Temperatur (HPHT) erhaltenen Diamant-Kristallkeim von mindestens 0,1 Karat in Gegenwart von 10⁻⁴ bis 1 Vol.-%, bezogen auf das Gesamtvolumen der Kohlenwasserstoff-Wasserstoff-Mischung, eines Metallocens oder eines thermischen Abbauproduktes davon, wobei der Kohlenwasserstoff in der Kohlenwasserstoff-Wasserstoff-Mischung eine Konzentration von etwa 0,5 bis 1,5 Vol.-% Kohlenwasserstoff aufweist, bezogen auf das Gesamtvolumen aus Kohlenwasserstoff und Wasserstoff, und er in der Lage ist, einen Dampfdruck von 13,3 Pa (0,1 Torr) unter Umgebungsbedingungen aufrechtzuerhalten, und das Metallocen oder dessen thermisches Abbauprodukt eine metallorganische Verbindung eines Metalles ist, ausgewählt aus der Klasse bestehend aus Eisen, Cobalt und Nickel.

2. Verfahren zum Züchten eines einkristallinen Diamanten nach Anspruch 1, worin das Metallocen Ferrocen ist.

3. Verfahren nach Anspruch 1, worin der Kohlenwasserstoff Methan ist.

4. Verfahren nach Anspruch 1, worin die Temperatur mit einem Mikrowellen-Plasma aufrechterhalten wird.

5. Verfahren nach Anspruch 1, worin die Temperatur durch Verwendung eines erhitzten Glühfadens aufrechterhalten wird.

## Revendications

1. Procédé de préparation d'un monocristal de diamant en supprimant la nucléation secondaire, comprenant :
le maintient d'un mélange hydrocarbure-hydrogène à une pression de 666 Pa à 2000 Pa (5 à 15 torr) et à une température d'environ 800°C à 1000°C en contact avec un germe de diamant HPHT au moins égal a 0,1 carat, en présence de 10⁻⁴ à 1 % en volume, par rapport au volume total du mélange hydrocarbure-hydrogène, d'un métallocène ou d'un produit de dégradation thermique de celui-ci, dans lequel l'hydrocarbure dans le mélange hydrocarbure-hydrogène a une concentration d'environ 0,5 à 1,5 % en volume d'hydrocarbures, par rapport au volume total d'hydrocarbures et d'hydrogène, et est capable de maintenir une pression de vapeur de 13,3 Pa (0,1 torr) dans des conditions ambiantes, et le métallocène, ou le produit de dégradation thermique de celui-ci est un composé organométallique d'un métal choisi dans le groupe constitué de fer, de cobalt et de nickel.

2. Procédé pour préparer un monocristal de diamant conforme à la revendication 1, dans lequel le métallocène est le ferrocène.

3. Procédé conforme à la revendication 1, dans lequel l'hydrocarbure est le méthane.

4. Procédé conforme à la revendication 1, dans lequel la température est maintenue à l'aide d'un plasma HF.

5. Procédé conforme à la revendication 1, dans lequel la'température est maintenue à l'aide d'un filament chauffé.
